# EUROPEAN PATENT APPLICATION

(11) **EP 2 620 463 A1**
(43) Date of publication of application: **31.07.2013**
(21) Application number: 11826882.0
(22) Date of filing: 21.09.2011
(51) Int. Cl.: C08G 69/00, H01L 23/29, H01L 23/31, H01L 31/042, H01L 51/50, H05B 33/04, H05K 3/28

(54) **POWDERED SEALANT AND SEALING METHOD**

(30) Priority: 22.09.2010 JP 2010212536
(71) Applicant: Daicel-Evonik Ltd., Shinjuku-ku, Tokyo 163-0912 (JP)
(72) Inventor: ARITA Hiroaki, Himeji-shi Hyogo 671-1281 (JP); NAKAIE Yoshiki, Himeji-shi Hyogo 671-1281 (JP); MUTSUDA Mitsuteru, Himeji-shi Hyogo 671-1281 (JP)
(74) Representative: Grünecker, Kinkeldey, Stockmair & Schwanhäusser
(86) International application number: PCT/JP2011/071519
(87) International publication number: WO 2012/039437

(57) **Abstract**

A sealant capable of tightly sealing an electric device at a low temperature and a sealing method of using the sealant are provided.

The sealant for molding and sealing a device comprises a copolyamide-series resin powder. The copolyamide-series resin may be a crystalline resin. The copolyamide-series resin may have a melting point or softening point of 75 to 160°C. The copolyamide-series resin may be a multiple copolymer, e. g., a binary or ternary copolymer. Further, the copolyamide-series resin may contain a unit derived from a long-chain component having a C₈₋₁₆alkylene group (at least one component selected from the group consisting of a C₉₋₁₇lactam and an aminoC₉₋₁₇alkanecarboxylic acid).

## Description

### TECHNICAL FIELD

The present invention relates to a powdery sealant suitable for sealing a device (or an electronic device) such as a printed wiring board mounted with an electronic part, a sealing method using the powdery sealant.

### BACKGROUND ART

In order to protect a precision part (or an electronic device) against moisture, dust and other unfavorable substances, the precision part (such as a semiconductor element, a printed wiring board, or a solar cell) is sealed (or encapsulated) with a resin. As the sealing method, a known method of sealing a precision part comprises placing the precision part in a mold cavity and injecting a resin into the cavity. This method uses a thermosetting resin having a low viscosity and a high flowability in many cases.

However, the thermosetting resin shortens a storage life due to an additive (such as a crosslinking agent) added to the thermosetting resin, and requires a relatively long time from injection of the resin into a mold cavity to curing of the resin. Thus, the thermosetting resin cannot achieve improvement of efficient production. Further, depending on the species of the resin, it is necessary to cure the resin after molding, which lowers production efficacy.

Moreover, it is known that a thermoplastic resin is injection-molded to seal a precision part. The thermoplastic resin, however, is practically injected at a relatively high temperature and high pressure, and thus a substrate or an electronic part mounted on a substrate is liable to damage and loses the reliability. Japanese Patent Application Laid-Open Publication No. 2000-133665 (JP-2000-133665A, Patent Document 1) discloses a method of sealing a printed wiring board mounted with an electronic part, the method comprising placing a printed wiring board equipped with an electronic part in a mold cavity and injecting a heat-melted polyamideresin having a temperature of 160 to 230°C into the mold cavity at a pressure range of 2.5 to 25 kg/cm². This document discloses in Examples that a polyamide resin (Series Number 187) manufactured by TRL (France) is injected into a mold at a melting temperature of 190°C and a pressure of 20 kg/cm² to seal a printed wiring board. This method, however, also exposes the electronic part to relatively high temperature and high pressure, and the electronic part is sometimes damaged.

Further, it is also known to seal a device using a film sealant. Japanese Patent Application Laid-Open Publication No. 2008-282906 (JP-2008-282906A, Patent Document 2) relates to a process for producing a solar cell module comprising a solar cell sealed between a substrate and a film by a resin; in the process, a first sealing-resin sheet substantially covering the whole surface of the substrate is disposed between the substrate and the solar cell, and a second sealing-resin sheet substantially covering the whole surface of the substrate is disposed between the film and the solar cell for preparing a layered structure. A plurality of the layered structures are stacked while a back plate is disposed outside the film of an uppermost layered structure, air between the substrate and the film is discharged and the resin is heat-melted and then cooled to seal the cell. This document discloses that the sealing-resin is selected from the group consisting of an ethylene-vinyl acetate copolymer, a poly(vinyl butyral), and a polyurethane.

Japanese Patent Application Laid-Open Publication No. 2009-99417 (JP-2009-99417A, Patent Document 3) discloses an organic electronic device sealing panel which comprises a substrate, an organic electronic device formed on the substrate, and a barrier film sealing the organic electronic device, and a hot-melt member is disposed between the organic electronic device and the barrier film. This document also discloses that the hot-melt member contains a moisture scavenger and a wax and that the hot-melt member is in a thin film having a thickness of not more than 100 µm. Moreover, Japanese Patent Application Laid-Open Publication No. 2009-99805 (JP-2009-99805A, Patent Document 4) discloses a hot-melt member for an organic thin-film solar cell, the member containing a moisture scavenger and a wax. These documents also disclose that the hot-melt member may be in the form of a thin-film, a plate, an amorphous or indefinite, and others.

The film sealant, however, has low adaptability to an uneven portion (a depressed or raised portion) of a device, and thus it is difficult to seal the detailed exact or minutiae formof the device tightly. Further, since the above hot-melt member comprises a wax as a main component, it is difficult to seal the device with higher adhesion.

Japanese Patent Application Laid-Open Publication No. 2001-234125 (JP-2001-234125A, Patent Document 5) discloses a powder coating material for thermal spray coating; in order to prevent the coating material from discoloring even when exposed to high-temperature flames in a coating process, the coating material comprises 0.05 to 2.0 parts by weight of a hindered phenol-series antioxidant and 0.05 to 2.0 parts by weight of a phosphite-series antioxidant relative to 100 parts by weight of a thermoplastic resin, and has a medium particle diameter of 50 to 300 µm, a bulk specific gravity of not less than 0.30 g/ml and a repose angle of not more than 35°. In this document, the thermoplastic resin includes a polyethylene resin, a polypropylene resin, a nylon-11 resin, a nylon-12 resin, an ethylene-vinyl acetate copolymer resin, an ethylene-acrylic acid copolymer resin, an ethylene-methacrylic acid copolymer resin, a modified polyethylene resin, and a modified polypropylene resin. An example using a nylon (polyamide) resin (trade name "Grilamid" manufactured by EMS-CHEMIE AG) is also described in this document.

Since the above-mentioned powder coating material, however, is melted and sprayed at a high temperature, there is a possibility to easily damage the electronic part in the sealing process and the reliability of the device.

### RELATED ART DOCUMENTS

### PATENT DOCUMENTS

Patent Document 1: JP-2000-133665A (Claims and Examples)
Patent Document 2: JP-2008-282906A (Claims)
Patent Document 3: JP-2009-99417A (Claims and [0024])
Patent Document 4: JP-2009-99805A (Claims)
Patent Document 5: JP-2001-234125A (Claims, [0008], and Example 6)

### SUMMARY OF THE INVENTION

### PROBLEMS TO BE SOLVED BY THE INVENTION

It is therefore an object of the present invention to provide a powdery sealant capable of tightly sealing an electronic device at a low temperature, and a sealing method using the sealant.

Another object of the present invention is to provide a powdery sealant which tightly seals a device even having an uneven portion or a narrow gap, and a sealing method using the sealant.

It is still another object of the present invention to provide a powdery sealant which can effectively protect an electronic device against moisture, dust or impact, and a sealing method using the sealant.

It is a further object of the present invention to provide an electronic device sealed with the powdery sealant.

### MEANS TO SOLVE THE PROBLEMS

The inventors of the present invention made intensive studies to achieve the above objects and finally found that a copolyamide-series resin powder achieves (1) shortening of sealing and molding cycles, (2) easy following and molding even an uneven surface of a device, (3) uninhibited device or substrate size, (4) sealing or molding a device even in a thin layer, and (5) molding a device or a substrate with high adhesion and seal-ability. The present invention was accomplished based on the above findings.

That is, the powdery sealant (or powdery encapsulant) according to the present invention is a sealant for molding and sealing (encapsulating) a device and comprises a copolyamide-series resin. The copolyamide-series resin may have a melting point or softening point of about 75 to 160°C, for example, a melting point of about 90 to 160°C. The copolyamide-series resin may be crystalline. The copolyamide-series resin may comprise a multiple copolymer, for example, at least one selected from the group consisting of a binary copolymer to a quaternary copolymer (e.g., a binary copolymer or a ternary copolymer). Further, the copolyamide-series resin may contain a unit (long-chain unit) derived from a long-chain component having a C₈₋₁₆alkylene group (such as a C₁₀₋₁₄alkylene group), for example, at least one component selected from the group consisting of a C₉₋₁₇lactam and an aminoC₉₋₁₇alkanecarboxylic acid. For example, the copolyamide-series resin may contain a unit derived from an amide-forming component (or an amide-formable component) for forming a polyamide selected from the group consisting of a polyamide 11, a polyamide 12, a polyamide 610, a polyamide 612, and a polyamide 1010; the copolyamide-series resin may comprise at least one member selected from the group consisting of a copolyamide 6/11, a copolyamide 6/12, a copolyamide 66/11, a copolyamide 66/12, a copolyamide 610/11, a copolyamide 612/11, a copolyamide 610/12, a copolyamide 612/12, a copolyamide 1010/12, a copolyamide 6/11/610, a copolyamide 6/11/612, a copolyamide 6/12/610, and a copolyamide 6/12/612. Moreover, the copolyamide-series resin may be a polyamide elastomer (a polyamide block copolymer) containing a unit (polyamide unit or block) derived from an amide-forming component for forming a polyamide selected from the group consisting of a polyamide 11, a polyamide 12, a polyamide 610, a polyamide 612 and a polyamide 1010 as a hard segment, if necessary. Further, the copolyamide-series resin may contain a unit derived from at least one component selected from the group consisting of laurolactam, aminoundecanoic acid, and aminododecanoic acid.

A process according to the present invention produces a device covered or molded with a copolyamide-series resin by applying (or spreading sprinkling) the powdery sealant on at least a region (or a portion) of the device, heat-melting the powdery sealant, and cooling the powdery sealant. Thus, the present invention also includes a device (a covered or molded device) of which at least a region (or a portion) is covered or molded with a copolyamide-series resin layer formed by heat-melting the powdery sealant.

Throughout this description, the term "copolyamide-series resin" means not only a copolymer (a copolyamide) of a plurality of amide-forming components, each forming a homopolyamide, but also a mixture of a plurality of copolymers (copolyamides) with different in kind, each containing units of a plurality of the amide-forming components.

### EFFECTS OF THE INVENTION

According to the present invention, a copolyamide-series resin powder can tightly (or closely) seal an electronic device at a low temperature and does not deteriorate the reliability of the device. Moreover, the sealant having a particulate form tightly seals a device even having an uneven portion or a narrow gap. Thus, the sealant can effectively protect an electronic device against moisture, dust, impact, or others.

### DESCRIPTION OF EMBODIMENTS

The powdery sealant (or particulate sealant) of the present invention comprises a copolyamide-series resin. The copolyamide-series resin includes a copolyamide (a thermoplastic copolyamide) and a polyamide elastomer.

The thermoplastic copolyamide may be an alicyclic copolyamide and usually an aliphatic copolyamide. The copolyamide may be formed by combination of a diamine component, a dicarboxylic acid component, a lactam component, and an aminocarboxylic acid component. The combination of the diamine component and the dicarboxylic acid component forms an amide bond of the copolyamide; each of the lactam component and the aminocarboxylic acid component can independently form an amide bond of the copolyamide. Thus, a pair of components (combination of a diamine component and a dicarboxylic acid component), a lactam component, and an aminocarboxylic acid component each may be referred to as an amide-forming component. From these viewpoints, the copolyamide can be obtained by copolymerization of a plurality of amide-forming components selected from the group consisting of a pair of components (combination of a diamine component and a dicarboxylic acid component), a lactam component, and an aminocarboxylic acid component. Moreover, the copolyamide can be obtained by copolymerization of at least one amide-forming component selected from the group consisting of a pair of components (combination of a diamine component and a dicarboxylic acid component), a lactam component and an aminocarboxylic acid component, and another amide-forming component different in kind from the above amide-forming component (or being the same kind as the above amide-forming component but different in the carbon number from the above amide-forming component). Moreover, the lactam component and the aminocarboxylic acid component may be presumed as an equivalent component as far as these components have the same carbon number and chain structure such as a branched structure. Thus, assuming that the pair of components composed of the diamine component and the dicarboxylic acid component is a first amide-forming component and that at least one of the lactam component and the aminocarboxylic acid component is a second amide-forming component, the copolyamide may for example be the following: a copolyamide of the first amide-forming component (the diamine component and the dicarboxylic acid component), wherein at least one of the diamine component and the dicarboxylic acid component comprises a plurality of components with different carbon number; a copolyamide of the first amide-forming component (the diamine component and the dicarboxylic acid component) and the second amide-forming component (at least one component selected from the group consisting of the lactam component and the aminocarboxylic acid component); a copolyamide of the second amide-forming component (at least one component selected from the group consisting of the lactam component and the aminocarboxylic acid component), wherein one of the lactam component and the aminocarboxylic acid component comprises a plurality of components with different carbon number; and a copolyamide of the lactam component and the aminocarboxylic acid component, wherein these components are the same or different in the carbon number from each other.

The diamine component may include an aliphatic diamine or alkylenediamine component (for example, a C₄₋₁₆alkylenediamine such as tetramethylenediamine, hexamethylenediamine, trimethylhexamethylenediamine, octamethylenediamine, or dodecanediamine), and others. These diamine components may be used singly or in combination. The preferred diamine component contains at least an alkylenediamine (preferably a C₆₋₁₄alkylenediamine, more preferably a C₆₋₁₂alkylenediamine).

If necessary, the diamine component may further contains an alicyclic diamine component {for example, a diaminocycloalkane such as diaminocyclohexane (e.g., a diaminoC₅₋₁₀cycloalkane); a bis(aminocycloalkyl)alkane [e.g., a bis(aminoC₅₋₈cycloalkyl)C₁₋₃alkane] such as bis(4-aminocyclohexyl)methane, bis(4-amino-3-methylcyclohexyl)methane, or 2,2-bis(4'-aminocyclohexyl)propane; a hydrogenated xylylenediamine} or an aromatic diamine component (e.g., m-xylylenediamine). The above diamine component (for example, an alicyclic diamine component) may have a substituent such as an alkyl group (a C₁₋₄alkyl group such as methyl group or ethyl group).

The proportion of the alkylenediamine component in the total diamine component may be about 50 to 100% by mol, preferably about 60 to 100% by mol (e.g., about 70 to 97% by mol), and more preferably about 75 to 100% by mol (e.g., about 80 to 95% by mol).

The dicarboxylic acid component may include an aliphatic dicarboxylic acid or alkanedicarboxylic acid component [for example, a dicarboxylic acid having about 4 to 36 carbon atoms or a C₄₋₃₆alkanedicarboxylic acid (such as adipic acid, pimelic acid, azelaic acid, sebacic acid, dodecanedioic acid, dimer acid or a hydrogenated product thereof)]. These dicarboxylic acid components may be used singly or in combination. The preferred dicarboxylic acid component contains a C₆₋₃₆alkanedicarboxylic acid (for example, a C₆₋₁₆alkanedicarboxylic acid, preferably a C₈₋₁₄alkanedicarboxylic acid). If necessary, the dicarboxylic acid component may further contains an alicyclic dicarboxylic acid component (for example, a C₅₋₁₀cycloalkane-dicarboxylic acid such as cyclohexane-1,4-dicarboxylic acid or cyclohexane-1,3-dicarboxylic acid) or an aromatic dicarboxylic acid (such as terephthalic acid or isophthalic acid). An alicyclic polyamide resin obtained from the alicyclic diamine component and/or the alicyclic dicarboxylic acid component in combination with the aliphatic diamine component and/or the aliphatic dicarboxylic acid component, as the diamine component and the dicarboxylic acid component, is known as a transparent polyamide having a high transparency.

The proportion of the alkanedicarboxylic acid component in the total dicarboxylic acid component may be about 50 to 100% by mol, preferably about 60 to 100% by mol (e.g., about 70 to 97% by mol), and more preferably about 75 to 100% by mol (e.g., about 80 to 95% by mol).

In the first amide-forming component, the diamine component can be used in the range of about 0.8 to 1.2 mol and preferably about 0.9 to 1.1 mol relative to 1 mol of the dicarboxylic acid component.

The lactam component may include, for example, a C₄₋₂₀lactam such as δ-valerolactam, ε-caprolactam, ω-heptalactam, ω-octalactam, ω-decanelactam, ω-undecanelactam, or ω-laurolactam (or ω-laurinlactam). The aminocarboxylic acid component may include, for example, a C₆₋₂₀aminocarboxylic acid such as ω-aminodecanoic acid, ω-aminoundecanoic acid, or ω-aminododecanoic acid. These lactam components and aminocarboxylic acid components may also be used singly or in combination.

The preferred lactam component contains a C₆₋₁₉lactam, preferably a C₈₋₁₇lactam, and more preferably a C₁₀₋₁₅lactam (e.g., laurolactam). Moreover, the preferred aminocarboxylic acid contains an aminoC₆₋₁₉alkanecarboxylic acid, preferably an aminoC₈₋₁₇alkanecarboxylic acid, and more preferably an aminoC₁₀₋₁₅alkanecarboxylic acid (such as aminoundecanoic acid or aminododecanoic acid).

The copolyamide may be a modified polyamide such as a polyamine having a branched chain structure formed by introduction of a small amount of a polycarboxylic acid component and/or a polyamine component.

The ratio (molar ratio) of the first amide-forming component (combination of both the diamine component and the dicarboxylic acid component) relative to the second amide-forming component (at least one amide-forming component selected from the group consisting of the lactam component and the aminocarboxylic acid component) can be selected from the range of 100/0 to 0/100 in a ratio of the former/the latter, and may for example be about 90/10 to 0/100 (e.g., about 80/20 to 5/95), preferably about 75/25 to 10/90 (e.g., about 70/30 to 15/85), and more preferably about 60/40 to 20/80 in a ratio of the former/the latter.

Further, the copolyamide preferably contains a long-chain component having a long fatty chain [a higher (or long-chain) alkylene group or alkenylene group] as a polymer unit (or contains a unit derived from the long-chain component). The long-chain component may include a component having a long fatty chain or alkylene group with about 8 to 36 carbon atoms (preferably a C₈₋₁₆alkylene group, and more preferably a C₁₀₋₁₄alkylene group). As the long-chain component, for example, there may be mentioned at least one component selected from the group consisting of a C₈₋₁₈alkanedicarboxylic acid (e.g., preferably a C₁₀₋₁₆alkanedicarboxylic acid, and more preferably a C₁₀₋₁₄alkanedicarboxylic acid), a C₉₋₁₇lactam (preferably a C₁₁₋₁₅lactam such as laurolactam), and an aminoC₉₋₁₇alkanecarboxylic acid (preferably an aminoC₁₁₋₁₅alkanecarboxylic acid such as aminoundecanoic acid or aminododecanoic acid). These long-chain components may be used singly or in combination. Among these long-chain components, a practically used component includes the lactam component and/or the aminoalkanecarboxylic acid component, for example, at least one component selected from the group consisting of laurolactam, aminoundecanoic acid, and aminododecanoic acid. The copolyamide containing a unit derived from the long-chain component has high water resistance as well as excellent adhesion to an electronic device, excellent abrasion resistance, and excellent impact resistance, and therefore protects an electronic device effectively.

The proportion of the long-chain component in the total monomer components for forming the copolyamide may be about 10 to 100% by mol (e.g., about 25 to 95% by mol), preferably about 30 to 90% by mol (e.g., about 40 to 85% by mol), and more preferably about 50 to 80% by mol (e.g., about 55 to 75% by mol).

Further, the copolyamide may be a multiple copolymer of the above amide-forming components, for example, any one of a binary copolymer to a quinary copolymer. The copolyamide is usually any one of a binary copolymer to a quaternary copolymer, and particularly a binary copolymer or a ternary copolymer.

The copolyamide practically contains, for example, an amide-forming component for forming a polyamide selected from the group consisting of a polyamide 11, a polyamide 12, a polyamide 610, a polyamide 612, and a polyamide 1010 as a constitutional unit (or contains a unit derived from the above amide-forming component). The copolyamide may be a copolymer of a plurality of the amide-forming components or may be a copolymer of one or a plurality of the amide-forming components and another amide-forming component (e.g., at least one amide-forming component for forming a polyamide selected from the group consisting of a polyamide 6 and a polyamide 66). Specifically, the copolyamide includes, for example, a copolyamide 6/11, a copolyamide 6/12, a copolyamide 66/11, a copolyamide 66/12, a copolyamide 610/11, a copolyamide 612/11, a copolyamide 610/12, a copolyamide 612/12, a copolyamide 1010/12, a copolyamide 6/11/610, a copolyamide 6/11/612, a copolyamide 6/12/610, and a copolyamide 6/12/612. In these copolyamides, each component separated by the slash "/" indicates an amide-forming component.

As the polyamide elastomer (polyamide block copolymer), there may be mentioned a polyamide block copolymer composed of a polyamide as a hard segment (or a hard block) and a soft segment (or a soft block), for example, a polyamide-polyether block copolymer, a polyamide-polyester block copolymer, and a polyamide-polycarbonate block copolymer.

The polyamide constituting the hard segment may be a homo- or co-polymer (a homopolyamide or a copolyamide) formed by one or a plurality of the above amide-forming components. The homopolyamide as the hard segment may contain the above-exemplified long-chain component as a constitutional unit. The preferred long-chain component includes the same as one described above. A representative homopolyamide includes a polyamide 11, a polyamide 12, a polyamide 610, a polyamide 612, a polyamide 1010, a polyamide 1012, and others. Moreover, the copolyamide as the hard segment includes the same as the above-exemplified copolyamide. Among these polyamides, the preferred polyamide includes a homopolyamide (such as a polyamide 11, a polyamide 12, a polyamide 1010, or a polyamide 1012).

A representative polyamide elastomer includes a polyamide-polyether block copolymer. In the polyamide-polyether block copolymer, the polyether (polyether block) may include, for example, a poly (alkylene glycol) [e.g., a poly(C₂₋₆alkylene glycol), preferably a poly(C₂₋₄alkylene glycol), such as a poly (ethylene glycol), a poly(propylene glycol), or a poly(tetramethylene glycol)].

As examples of the polyamide-polyether block copolymer, there may be mentioned a block copolymer obtainable by copolycondensation of a polyamide block having a reactive terminal group and a polyether block having a reactive terminal group, for example, a polyetheramide [e.g., a block copolymer of a polyamide block having a diamine end and a poly (alkylene glycol) block (or a polyoxyalkylene block) having a dicarboxyl end, and a block copolymer of a polyamide block having a dicarboxyl end and a poly (alkylene glycol) block (or a polyoxyalkylene block) having a diamine end]; and a polyetheresteramide [e.g., a block copolymer of a polyamide block having a dicarboxyl end and a poly(alkylene glycol) block (or a polyoxyalkylene block) having a dihydroxy end]. The polyamide elastomer may have an ester bond. In order to improve the acid resistance, the polyamide elastomer may be free from an ester bond. Moreover, a commercially available polyamide elastomer usually has no or few amino group.

In the polyamide elastomer (the polyamide block copolymer), the number average molecular weight of the soft segment (e.g., a polyether block, a polyester block, and a polycarbonate block) may be selected from the range of, e.g., about 100 to 10000, and may be preferably about 300 to 6000 (e.g., about 300 to 5000), more preferably about 500 to 4000 (e.g., about 500 to 3000), and particularly about 1000 to 2000.

Moreover, in the polyamide elastomer (the polyamide block copolymer), the ratio (weight ratio) of the polyamide block (polyamide segment) relative to the soft segment block may for example be about 75/25 to 10/90, preferably about 70/30 to 15/85, and more preferably about 60/40 to 20/80 (e.g., about 50/50 to 25/75) in a ratio of the former/the latter.

These copolyamide-series resins may be used singly or in combination. Among these copolyamide-series resins, in view of the ability to seal an electronic device, the copolyamide (a non-polyamide elastomer or a polyamide random copolymer) is preferred. In particular, it is preferable that the copolyamide contain an amide-forming component derived from a polyamide 12 as a constitutional unit.

The amino group concentration of the copolyamide-series resin is not particularly limited to a specific one, and may for example be about 10 to 300 mmol/kg, preferably about 15 to 280 mmol/kg, and more preferably about 20 to 250 mmol/kg.

The carboxyl group concentration of the copolyamide-series resin is not particularly limited to a specific one, and may for example about 10 to 300 mmol/kg, preferably about 15 to 280 mmol/kg, and more preferably about 20 to 250 mmol/kg. A high carboxyl group concentration of a copolyamide-series resin achieves high heat stability, which is advantageous.

The number average molecular weight of the copolyamide-series resin can be selected from the range of, e. g. , about 5000 to 200000; and may for example be about 6000 to 100000, preferably about 7000 to 70000 (e.g., about 7000 to 15000), and more preferably about 8000 to 40000 (e.g., about 8000 to 12000); and is usually about 8000 to 30000. The molecular weight of the copolyamide-series resin can be measured by gel permeation chromatography using HFIP (hexafluoroisopropanol) as a solvent in terms of poly(methyl methacrylate).

The amide bond content per molecule of the copolyamide-series resin can be selected from the range of, for example, not more than 100 units. In respect of the ability to seal a device, the amide bond content may be about 30 to 90 units, preferably about 40 to 80 units, and more preferably about 50 to 70 units (e.g., about 55 to 60 units). The amide bond content can be calculated, for example, by dividing a number average molecular weight by a molecular weight of a repeating unit (1 unit).

The copolyamide-series resin may be amorphous (or non-crystalline) or may be crystalline. The copolyamide-series resin may have a degree of crystallinity of, for example, not more than 20% and preferably not more than 10%. The degree of crystallinity can be measured by a conventional method, for example, a measuring method based on density or heat of fusion, an X-ray diffraction method, and an absorption of infrared rays.

The thermal melting property of the amorphous copolyamide-series resin can be determined based on a softening temperature measured by a differential scanning calorimeter. The melting point of the crystalline copolyamide-series resin can be measured by a differential scanning calorimeter (DSC).

The copolyamide-series resin (or the copolyamide or the polyamide elastomer) may have a melting point or softening point of about 75 to 160°C (e.g., about 80 to 150°C), preferably about 90 to 140°C (e.g., about 95 to 135°C), and more preferably about 100 to 130°C; and is usually about 90 to 160°C (e.g., about 100 to 150°C). Because the copolyamide-series resin has a low melting point or softening point, the melted or molten resin is useful to follow an external shape (or a surface) of a device [e.g., an uneven surface of a device (such as a corner region forming a stepped section)]. When the copolyamide-series resin contains components compatible with each other to show a single peak by DSC, the melting point of the copolyamide-series resin means a temperature at the single peak; when the copolyamide-series resin contains components incompatible with each other to show a plurality of peaks by DSC, the melting point of the copolyamide-series resin means the highest temperature out of a plurality of temperature values showing the peaks.

The copolyamide-series resin preferably has a high melting flowability in order to follow an external shape (or surface) of a device (such as an uneven surface of a device) and to allow the copolyamide-series resin to enter in a gap (or a space) orotherareas. The copolyamide-series resin may have a melt flow rate (MFR) of about 1 to 350 g/10 minutes, preferably about 3 to 300 g/10 minutes, and more preferably about 5 to 250 g/10 minutes at a temperature of 160°C under a load of 2.16 kg.

To the copolyamide-series resin, a homopolyamide (for example, a homopolyamide of a component for forming the copolyamide) may be added as far as the copolyamide-series resin deteriorates its characteristics such as adhesion. The ratio of the homopolyamide may be not more than 30 parts by weight (e.g., about 1 to 25 parts by weight), preferably about 2 to 20 parts by weight, and more preferably about 3 to 15 parts by weight relative to 100 parts by weight of the copolyamide-series resin.

The powder mixture of the copolyamide-series resin may be a mixture of each copolyamide particle or a mixture of a particle of a molten mixture of each copolyamide. In the case where the copolyamide-series resin is a mixture, each polyamide may have compatibility with each other.

If necessary, the copolyamide-series resin particle for the powdery sealant of the present invention may contain various additives, for example, a filler, a stabilizer (such as a heat stabilizer or a weather-resistant stabilizer), a coloring agent, a plasticizer, a lubricant, a flame retardant, an antistatic agent, and a thermal conductive agent. The additives may be used alone or in combination. Among these additives, an additive such as the stabilizer or the thermal conductive agent is widely used.

As described above, the powdery sealant of the present invention may be a particulate comprising a copolyamide-series resin, a mixture of a plurality of copolyamide-series resins, or a mixture (a copolyamide-series resin composition) containing a copolyamide-series resin and another component (e.g., a homopolyamide, an additive).

The form of the copolyamide-series resin particle of the powdery sealant (or particulate sealant) is not particularly limited to a specific one. Moreover, the average particle size of the copolyamide-series resin particle of the powdery sealant is not particularly limited to a specific one as far as the particle has powder flowability allowing for flowing on a surface of the device. For example, the average particle size of the copolyamide-series resin particle may be about 1 to 500 **µm** (e.g., about 5 to 300 **µm**), preferably about 10 to 250 **µm** (e.g., about 25 to 200 **µm**), and more preferably about 50 to 200 **µm** (e.g., about 75 to 150 **µm**) and is usually about 80 to 90 **µm**. The average particle size can be measured by a measuring apparatus using a laser diffraction method (a light-scattering method), for example, LA920 (manufactured by HORIBA).

The powdery or particulate sealant may be produced by pulverization using a conventional method (for example, freeze pulverization) and, if necessary, classification using a sieve.

It is sufficient that the powdery sealant comprises a copolyamide-series resin. If necessary, the powdery sealant may contain another resin, for example, a thermosetting resin (such as an epoxy resin) or a thermoplastic resin (such as an ethylene-vinyl acetate copolymer) or may be a mixture of the copolyamide-series resin particle and a particle of the other resin. The ratio of another resin relative to 100 parts by weight of the copolyamide-series resin may for example be about not more than 100 parts by weight (e. g. , about 1 to 80 parts by weight), preferably about 2 to 70 parts by weight, more preferably about 2 to 50 parts by weight, and particularly not more than 30 parts by weight (e. g. , about 3 to 20 parts by weight) .

Use of the copolyamide-series resin in the form of a particulate as a sealant (1) shortens sealing and molding cycles compared with a thermosetting resin. Moreover, (2) although a film sealant cannot follow an uneven surface or a surface having depressed and raised portions (in particular, a surface having acutely or markedly depressed and raised portions), the powdery sealant can easily follow the surface having depressed and raised portions to allow covering or sealing the surface; (3) in an injection molding (in particular, a low-pressure injection molding) or a molding of a hot-melt resin, there is a limitation in the size of a device or substrate in connection with a mold, and only a device or substrate having a size of about 10 cmx 10 cm at the most can be sealed. In contrast, the powdery sealant can seal a device without limitation in the size of the device. Further, (4) differently from the injection molding or the molding of the hot-melt resin, the powdery sealant even in a thin layer form surely molds to a device and thus can be lightweight and small-sized, and (5) the powdery sealant ensures molding of a device with high adhesion and high seal-ability. Thus, the powdery sealant can thermally adhere to an electronic device or the like, thereby protecting the device against water, moisture, contamination due to adhesion of dust, and others. In particular, the powdery sealant containing a copolyamide-series resin improves adhesion to the device, imparts a high impact resistance and abrasion resistance to the device, and improves a protective effect relative to the device.

According to the method of the present invention, a device covered or molded with a copolyamide-series resin can be produced by a step for applying or spreading the powdery sealant on at least part (a region) of a device, a step for heat-melting the powdery sealant, and cooling the powdery sealant.

The device may include various organic or inorganic devices, each requiring molding or sealing, for example, a precision part (e.g., a semiconductor element, an electroluminescent (EL) device, a light emitting diode, and a solar cell) or an electronic part (in particular, a precision electronic part or an electronic device) such as a circuit board (a printed wiring board) equipped or mounted with a part (such as various electronic parts or electronic devices).

In the applying step, the powdery sealant may be applied or spread (sprinkled or sprayed) on the whole of the device, or the device may optionally be masked and then the powdery sealant may be applied or spread (sprinkled or sprayed) on only a predetermined site. The powdery sealant may be attached to the device by immersing the device in the powdery sealant or by speading (or spraying) the powdery sealant on the device placed on a predetermined member. Further, a large amount of the powdery sealant may be applied or attached to a predetermined portion (for example, a rising portion or a corner portion). The device may be coated with a volatile liquid in order to retain (or hold) the powdery sealant on the device temporarily. Moreover, if necessary, the device may be heated (for example, heated to a temperature not lower than the melting point or softening point of the sealant) for attaching (or partially melt-attaching) the powdery sealant to the device. In this case, an excess amount of the powdery sealant may be removed by vibration, revolution (or rolling), wind force, or other means. Moreover, in order to uniformly attach the powdery sealant to the device, the powdery sealant may be spread on or attached to the device by forming a fluidized bed of the powdery sealant in a container while feeding air from a bottom porous plate of the container, and immersing the device (optionally heated) in the fluid bed. Further, in order to attach the powdery sealant to details of the device, the powdery sealant may be spread on or attached to the device while rotating the device. The amount of the powdery sealant may be selected depending on the molding or covering amount, and may for example be about 0.1 to 100 mg/cm², preferably about 0.5 to 50 mg/cm², and more preferably 1 to 30 mg/cm².

In the heating step, the copolyamide-series resin adheres (or melt-adheres) to the device by heat-melting the powdery sealant depending on the heat resistance of the device. The heating temperature may for example be about 75 to 200°C, preferably about 80 to 180°C, and more preferably about 100 to 175°C (e.g., about 110 to 150°C) depending on the melting point or softening point of the copolyamide-series resin. The heating can be carried out in air or in an inert gas atmosphere. The heating can be conducted in an oven, and if necessary, may use ultrasonic heating or high-frequency heating (electromagnetic heating). The heat-melting step may be carried out under an atmospheric pressure or an applied pressure. If necessary, the heat-melting step may be carried out under a reduced-pressure condition for defoaming.

Further, if necessary, the applying step and the heating step may be repeated. Moreover, after a copolyamide-series resin layer is formed on a first side (e.g., an upper surface) of the device as described above, a second side (e.g., a bottom surface) of the device is applied or sprinkled with the powdery sealant for molding and sealing both sides of the device including end faces thereof.

In the cooling step, the molten (or melt-adhered) copolyamide-series resin may be cooled spontaneously, or stepwise or continuously, or rapidly.

By these steps, a device at least a region of which is covered or molded with the copolyamide-series resin layer formed by heat-melting (or thermal adhesion) of the powdery sealant can be obtained. The molding site of the device is usually a fragile or delicate site, for example, a site equipped with an electronic device and a wiring site.

According to the present invention, since the powdery sealant can be melted to adhere to the device at a relatively low temperature, the reliability of the device can be improved due to a low thermal damage to the device. Moreover, differently from injection molding or the like, since a high pressure is not applied to the device, the device is not damaged due to a pressure. Thus, the film sealant molds and seals the device with high reliability. In addition, the heating and cooling in a short period of time improves the production of the molded or sealed device greatly.

### EXAMPLES

The following examples are intended to describe this invention in further detail and should by no means be interpreted as defining the scope of the invention. The methods of the evaluation of evaluation items in the examples are as follows.

### [Sealing performance]

The sealing performance of a sealant was evaluated for both of a flat surface of a substrate and a protruded portion having a side face (height: 2 mm or 10 mm) rising perpendicularly from a flat surface of a substrate on the basis of the following criteria.
5 : The flat surface or the protrudedportion is wholly covered with the sealant.
4 : The flat surface or the protruded portion is almost wholly covered, but entering of air is partly observed between the substrate and the sealant.
3: Half of the sealant peels off from the flat surface or the protruded portion.
2: The sealant partly adheres to the flat surface or the protruded portion, but the sealant mostly peels off from the flat surface or the protruded portion.
1: The sealant wholly peels off from the flat surface or the protruded portion.

### [Peel test]

A test piece comprising a glass epoxy substrate sealed with a sealant of Examples and Comparative Examples was evaluated for the adhesion between the substrate and the film according to a cross-cut test.

### [Water-resistant test]

A test piece comprising a glass epoxy substrate sealed with a sealant of Examples and Comparative Examples was evaluated for the water resistance according to a cross-cut test after being immersed in water of a thermostatic bath at 23°C for 100 hours.

### Example 1

A copolyamide (VESTAMELT X1038p1 manufactured by Evonik, containing a C₁₀₋₁₄alkylene group, average particle size: 80 µm, range of particle size: 0.5 to 160 µm, melting point: 125°C (DSC), melt flow rate: 15 g/10 minute (a temperature of 160°C and a load of 2.16 kg)) was uniformly spread on an electronic substrate (200 mm x 200 mm) made of a glass epoxy resin using a wire mesh (or wire gauze) (opening size: 200 µm), and then heated under an atmosphere of a temperature of 170°C to give a substrate coated with the transparent resin.

### Example 2

A copolyamide (VESTAMELT X1051 manufactured by Evonik, containing a C₁₀₋₁₄alkylene group, melting point: 130°C (DSC), melt flow rate: 15 g/10 minute (a temperature of 160°C and a load of 2.16 kg)) was pulverized and passed through a sieve to give a powdery resin particle having an average particle size of 80 µm and a particle size range of 0.5 to 160 µm. The resin particle was uniformly spread on an electronic substrate (200 mm x 200 mm) made of a glass epoxy resin using a wire mesh (opening size: 250 µm), and then heated under an atmosphere of a temperature of 180°C to give a substrate coated with the transparent resin.

### Example 3

A copolyamide (VESTAMELT X1333p1 manufactured by Evonik, containing a C₁₀₋₁₄alkylene group, average particle size: 80 µm, range of particle size: 0.5 to 160 µm, melting point: 105°C (DSC), melt flow rate: 15 g/10 minute (a temperature of 160°C and a load of 2.16 kg)) was uniformly spread on an electronic substrate (200 mm x 200 mm) made of a glass epoxy resin using a wire mesh (opening size: 200 µm) , and then heated under an atmosphere of a temperature of 170°C to give a substrate coated with the transparent resin.

### Example 4

A copolyamide (VESTAMELT 4680 manufactured by Evonik, containing a C₁₀₋₁₄alkylene group, average particle size: 80 µm, range of particle size: 0.5 to 160 µm, melting point: 105°C (DSC), melt flow rate: 35 g/10 minute (a temperature of 160°C and a load of 2.16 kg)) was uniformly spread on an electronic substrate (200 mm x 200 mm) made of a glass epoxy resin using a wire mesh (opening size: 200 µm), and then heated under an atmosphere of a temperature of 170°C to give a substrate coated with the transparent resin.

### Example 5

A copolyamide (VESTAMELT Z2131 manufactured by Evonik, containing a C₁₀₋₁₄alkylene group, average particle size: 80 µm, range of particle size: 0.5 to 160 µm, melting point: 90°C (DSC), melt flow rate: 160 g/10 minute (a temperature of 160°C and a load of 2.16 kg)) was uniformly spread on an electronic substrate (200 mm x 200 mm) made of a glass epoxy resin using a wire mesh (opening size: 300 µm), and then heated under an atmosphere of a temperature of 130°C to give a substrate coated with the transparent resin.

### Example 6

An electronic substrate (200 mm x 200 mm) made of a glass epoxy resin, having an electronic part (height: 20 mm) mounted thereon was heated at 170°C for 2 minutes. Then, a copolyamide (VESTAMELT X1038p1 manufactured by Evonik, containing a C₁₀₋₁₄alkylene group, average particle size: 80 µm, range of particle size: 0.5 to 160 µm, melting point: 125°C (DSC), melt flow rate: 15 g/10 minute (a temperature of 160°C and a load of 2.16 kg)) was spread on the substrate through a wire mesh (opening size: 200 µm) . An excess amoung of the resin particle was removed, and the attached copolyamide was heated for 2 minutes under an atmosphere of a temperature of 170°C to give a mounted substrate (including the electronic part) coated with the transparent resin.

### Comparative Example 1

A polyamide 12 (DAIAMID A1709 manufactured by Daicel-Evonik Ltd., average particle size: 80 µm, range of particle size: 0. 5 to 160 µm, melting point: 178°C (DSC) , melt flow rate: 70 g/10 minute (a temperature of 190°C and a load of 2.16 kg)) was uniformly spread on an electronic substrate (200 mm x 200 mm) made of a glass epoxy resin, and then heated under an atmosphere of a temperature of 220°C to give a substrate coated with the transparent resin.

Each sealant used in Examples and Comparative Examples was evaluated for sealing performance, peeling property, and water resistance. The results are shown in Table 1. In the table, each numerical value in the peel test and the water-resistant test indicates the number of peeled squares out of 100 squares in the cross-cut peel test.

**Table 1**

| | Examples | | | | | | Comparative Examples |
|---|---|---|---|---|---|---|---|
| | 1 | 2 | 3 | 4 | 5 | 6 | 1 |
| Flat | 5 | 5 | 5 | 5 | 5 | 5 | 5 |
| Protruded portion 2 mm | 5 | 5 | 5 | 5 | 5 | 5 | 3 |
| Protruded portion 20 mm | 5 | 5 | 5 | 5 | 5 | 4 | 1 |
| Peel test | 0 | 0 | 0 | 1 | 2 | 5 | 100 |
| Water-resistant test | 0 | 0 | 0 | 0 | 2 | 0 | 100 |

As apparent from Table 1, compared with Comparative Examples, Examples show high sealing performance in both of the flat portion and the protruded portion as well as have excellent adhesion and water resistance.

### INDUSTRIAL APPLICABILITY

The present invention is useful for molding or sealing of an electronic device or electronic part (e.g., a semiconductor element, an EL device, and a solar cell) or a printed wiring board equipped with a variety of electronic parts or electronic devices at a low temperature.

## Claims

1. A powdery sealant for molding and sealing a device, the sealant comprising a copolyamide-series resin.

2. A powdery sealant according to claim 1, wherein the copolyamide-series resin has a melting point or softening point of 75 to 160°C.

3. A powdery sealant according to claim 1 or 2, wherein the copolyamide-series resin is a crystalline resin.

4. A powdery sealant according to any one of claims 1 to 3, wherein the copolyamide-series resin is a crystalline resin and has a melting point of 90 to 160°C.

5. A powdery sealant according to any one of claims 1 to 4, wherein the copolyamide-series resin comprises a multiple copolymer.

6. A powdery sealant according to any one of claims 1 to 5, wherein the copolyamide-series resin comprises at least one selected from the group consisting of a binary copolymer to a quaternary copolymer.

7. A powdery sealant according to any one of claims 1 to 6, wherein the copolyamide-series resin contains a unit derived from a long-chain component having a C₈₋₁₆alkylene group.

8. A powdery sealant according to any one of claims 1 to 7, wherein the copolyamide-series resin contains a unit derived from at least one component selected from the group consisting of a C₉₋₁₇lactam and an aminoC₉₋₁₇alkanecarboxylic acid.

9. A powdery sealant according to any one of claims 1 to 8, wherein the copolyamide-series resin contains a unit derived from an amide-forming component for forming a polyamide selected from the group consisting of a polyamide 11, a polyamide 12, a polyamide 610, a polyamide 612, and a polyamide 1010.

10. A powdery sealant according to any one of claims 1 to 9, wherein the copolyamide-series resin comprises at least one member selected from the group consisting of a copolyamide 6/11, a copolyamide 6/12, a copolyamide 66/11, a copolyamide 66/12, a copolyamide 610/11, a copolyamide 612/11, a copolyamide 610/12, a copolyamide 612/12, a copolyamide 1010/12, a copolyamide 6/11/610, a copolyamide 6/11/612, a copolyamide 6/12/610, and a copolyamide 6/12/612.

11. A powdery sealant according to any one of claims 1 to 10, wherein the copolyamide-series resin contains a unit derived from at least one component selected from the group consisting of laurolactam, aminoundecanoic acid, and aminododecanoic acid.

12. A process for producing a device covered or molded with a copolyamide-series resin, the process comprising:
applying a powdery sealant recited in any one of claims 1 to 11 to at least a region of a device,
heat-melting the powdery sealant, and
cooling the powdery sealant.

13. A device of which at least a region is covered or molded with a copolyamide-series resin layer, the layer being formed by heat-melting a powdery sealant recited in any one of claims 1 to 11 on the device.
